# EUROPEAN PATENT APPLICATION

(11) **EP 4 454 766 A1**
(43) Date of publication of application: **30.10.2024**
(21) Application number: 24170570.6
(22) Date of filing: 16.03.2016
(51) Int. Cl.: B05D 5/06, B05D 1/00, C23C 14/04, C23C 14/28, H05K 3/20, B05D 3/06, H05K 3/12, B05D 1/28

(54) **METHOD FOR DEPOSITING A FUNCTIONAL MATERIAL ON A SUBSTRATE**

(62) Divisional of application: 16894747.1
(71) Applicant: NCC Nano, LLC, Dallas, TX 75251 (US)
(72) Inventor: HENDRIKS, Rob, Jacob, 5654 BN Eindhoven (NL); SCRODER, Kurt A., Coupland, 78615 (US); MUNSON, Charles, C., Dallas, 75230 (US)
(74) Representative: Mewburn Ellis LLP

(57) **Abstract**

A method for depositing a functional material on a substrate is disclosed. An optically transparent plate having a first surface and a second surface with one or more wells is provided. After coating the second surface with a thin layer of light-absorbing material, the wells are filled with a functional material. The plate is then irradiated with a pulsed light to heat the layer of light-absorbing material in order to generate gas at an interface between the layer of light-absorbing material and the functional material to release the functional material from the wells onto a receiving substrate located adjacent to the plate.

## Description

### BACKGROUND OF THE INVENTION

### 1. Technical Field

The present invention relates to printing processes in general, and, in particular, to a method for selectively depositing a functional material on a substrate.

### 2. Description of Related Art

A common method for selectively depositing a functional material on a substrate is via printing. The functional material needs to be formulated with other materials before the functional material can be printed on a substrate. A formulation can typically be formed by dispersing the functional material in a solvent or liquid; thus, the formulation is generally wet. The formulation is often referred to as an ink or paste, depending on the viscosity.

A formulation (either ink or paste) typically includes certain additives intended to make the printing process easier and more reliable, but those additives may also interfere with the properties of the functional material. If the additives within the formulation do not substantially interfere with the intended functions of the functional material to be deposited, the additives can stay; otherwise, the additives must be removed. The removal of additives can be somewhat inconvenient if not impossible.

Consequently, it would be desirable to provide an improved method for printing a functional material on a substrate.

### SUMMARY OF THE INVENTION

In accordance with a preferred embodiment of the present invention, an optically transparent plate having a first surface and a second surface with one or more wells is provided. After coating the second surface with a thin layer of light-absorbing material, the wells are filled with a functional material. The plate is then irradiated with a pulsed light to heat the layer of light-absorbing material in order to generate a gas at an interface between the layer of light-absorbing material and the functional material to release the functional material from the wells onto a receiving substrate.

All features and advantages of the present invention will become apparent in the following detailed written description.

### BRIEF DESCRIPTION OF THE DRAWINGS

The invention itself, as well as a preferred mode of use, further objects, and advantages thereof, will best be understood by reference to the following detailed description of an illustrative embodiment when read in conjunction with the accompanying drawings, wherein:
Figures **1A-1B** depict a laser induced forward transfer process;
Figure **2** is a flow diagram of a method for depositing a functional material on a substrate, in accordance with a preferred embodiment of the present invention; and
Figures **3A-3E** illustrate the method of Figure 2.

### DETAILED DESCRIPTION OF A PREFERRED EMBODIMENT

Ideally, instead of printing a functional material on a substrate, selectively depositing a pure functional material on a substrate is most preferable, but it is almost never done. To a certain extent, printing a near pure functional material, such as pastes with high solids content, can be performed by using a Laser Induced Forward Transfer (LIFT) process.

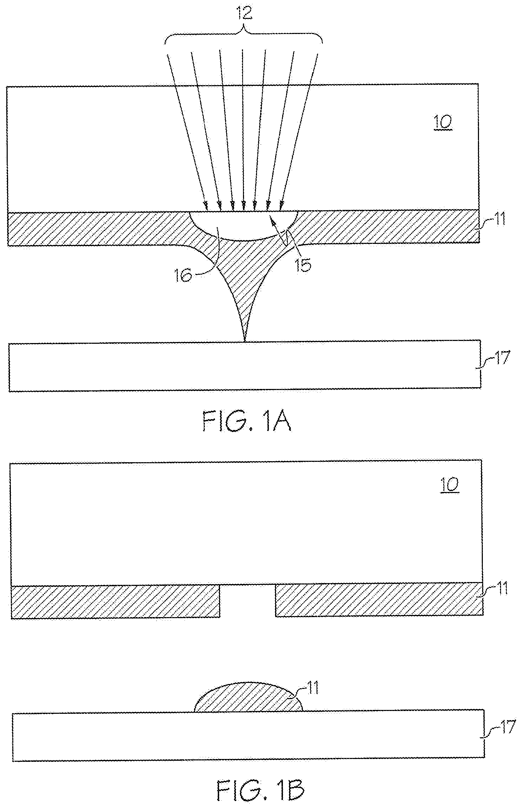

Referring now to the drawings and in particular to Figures **1A-1B****,** there is depicted the LIFT process. Initially, a functional material **11** is placed on one side of a donor substrate **10** that is at least partially optically transparent. A laser beam **12** is then focused on the other side of donor substrate **10** to a point near an interface **15** between functional material **11** and donor substrate **10,** as shown in Figure **1A****.** A gas **16** is generated at interface **15** that propels functional material **11** onto a receiver substrate **17,** as shown in Figure **1B****.**

There are several disadvantages to the LIFT process. First, the thicker the deposition, the lower the resolution of a final print. Second, since only a single spot of functional material can be transferred at a time, the LIFT process can only be performed in a serial manner. Third, there is a considerable amount of waste in the LIFT process because only a relatively small portion of the functional material on the donor substrate is utilized. Finally, and perhaps the biggest disadvantages of the LIFT process is that there are specific requirements on the dynamic characteristics of the functional material to be printed. In other words, the LIFT process is not suitable for all types of functional materials, and the printing parameters need to be fine-tuned for each type of functional materials. The margin of error for the tuning is relatively small because the homogeneity of the layer thickness and the viscosity will vary across the entire donor substrate.

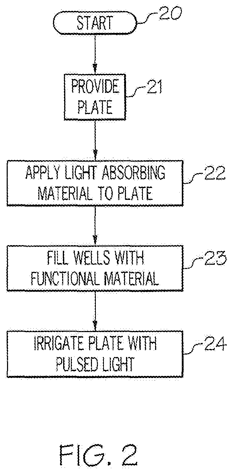

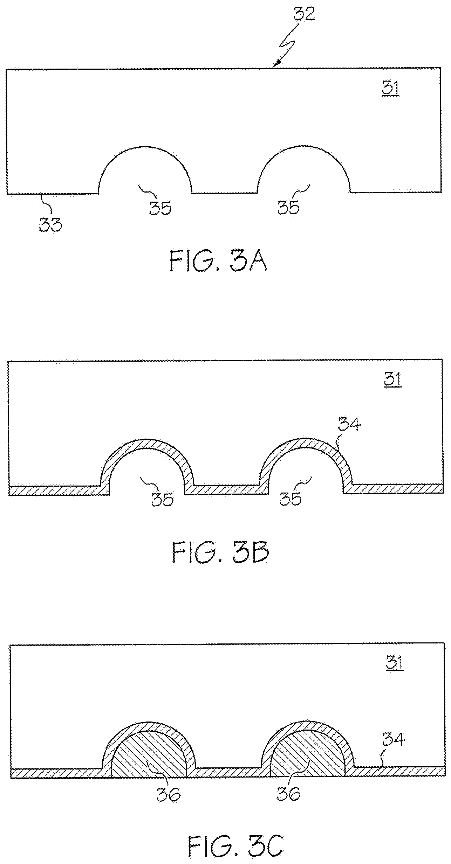

With reference now to Figure **2****,** there is illustrated a method for depositing a functional material on a substrate, in accordance with a preferred embodiment of the preset invention. Starting at block **20,** an optically transparent plate is provided, as shown in block **21.** The optically transparent plate is preferably made of quartz. The optically transparent plate, which is depicted as a plate **31** in Figure **3A****,** includes a first surface **32** and a second surface **33.** First surface **32** is preferably flat, but it can also be curved. Second surface **33** is preferably dimpled with multiple wells **35.** Although multiple wells are shown in Figure **3A****,** it is understood by those skilled in the art that second surface **33** may have only one well.

A thin light-absorbing material layer **34** is then applied to second surface **33** of plate **31,** as depicted in block **22** and in Figure **3B****.** Light-absorbing material layer **34** needs to be thermally stable (*i.e.*, thermal shock resistant). Preferably, light-absorbing material layer **34** is made of tungsten.

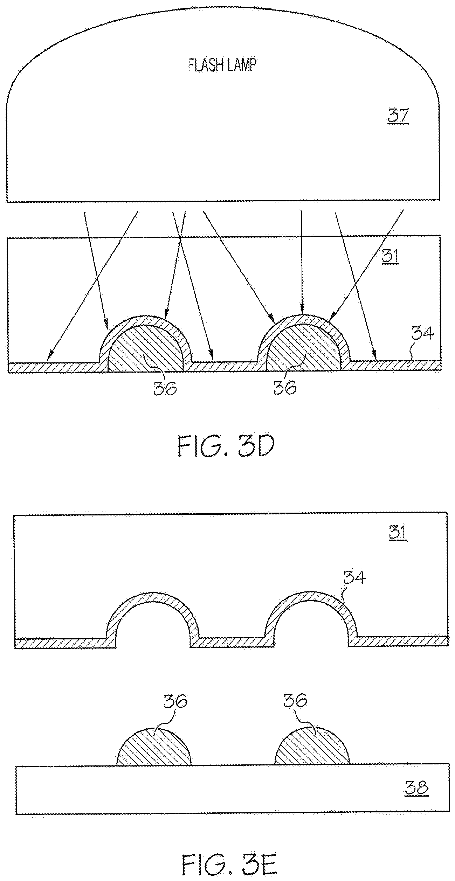

Next, wells **35** of plate **31** are then filled with a functional material **36,** as shown in block **23** and in Figure **3C****.** Functional material **36** can be in the form of an ink or paste. A squeegee or doctor blade can be utilized to fill wells **35** with functional material **36.** After wells **35** have been filled with functional material **36,** plate **31** is irradiated by a pulsed light, preferably on first surface **32,** as depicted in block **24** and in Figure **3D****.** Preferably, the pulsed light is generated by a flashlamp **37.**

When the pulsed light hits plate **31,** a portion of the photons are converted into phonons that subsequently heat light-absorbing material layer **34.** While light-absorbing material layer **34** is being heated, functional material **36** within wells **35** will be heated through thermal diffusion (primarily conduction). When the boiling or sublimation phase change temperature of one or multiple components of functional material **36** has been reached at an interface between light-absorbing material layer **34** and functional material **36,** gas is generated at the interface between light-absorbing material layer **34** and functional material **36.** The gas then expels functional material **36** from plate **31** to a receiving substrate **38,** as shown in Figure **3E****.** The transfer of functional material **36** may also be assisted by gravity.

The above-mentioned steps may be repeated by re-applying the functional material to wells **35** of plate **31** followed by another exposure of pulsed light from flashlamp **37** to expel the functional material from wells **35** onto receiving substrate **37.**

The shape of wells **35** can be adjusted to help controlling the expulsion of functional material **36,** and to improve the filling of functional material **36.**

It is important to supply a uniform application of heat onto light-absorbing material layer **34** in order to make sure functional material **36** is heated in a consistent manner such that functional material **36** in wells **35** loses adhesion to plate **31** at the same time. If not, functional material **36** will be ejected in an inconsistent direction. Furthermore, if functional material **36** were to be inconsistently heated, functional material **36** could have inconsistent properties after expulsion. An ejection of functional material **36** from wells **35** undergoes almost no shear stress.

A uniform application of heat on light-absorbing material layer **34** is preferably achieved by using a non-collimated light source with a spatially uniform beam profile. As each of wells **35** has a curved surface, the radiant power at the surface of wells **35** is proportional to the cosine of the incident angle of the light impinging upon them. Thus, a collimated beam of light would not produce a uniform heating profile unless the spatial intensity of the beam varied as the 1/cosine of the incident angle of the light over each of wells **35.** This problem does not exist when the pulsed light is non-collimated.

An example of a non-collimated light source that can have a spatially uniform beam intensity is flashlamp **37** mentioned above. Another example of a non-collimated source is a laser coupled to a waveguide. The laser alone is a coherent source, but after passing through a waveguide, a laser beam from the laser loses its coherency, and therefore becomes non-collimated. When the intensity of the laser beam is spatially uniform, a uniform heating of light-absorbing material layer **34** can be achieved.

In order to use a flashlamp, such as flashlamp **37,** as a light source, the flashlamp preferably has a beam uniformity of less than 5% and more preferably less than 2%, and the intensity is preferably greater than 5 KW/cm², and more preferably, greater than 10 KW/cm². In addition, the pulse of light is preferably be less than 1 ms, and more preferably less than 0.2 ms. The higher the thermal diffusivity of plate 30 and light-absorbing material layer **34,** the higher the intensity and the shorter the pulse length are required. The uniformity of the intensity of the beam is preferably less than 5%, and more preferably less than 2%.

If an under-powered flashlamp were to be used, then functional material **36** would not be properly released from wells **35.** More specifically, if a pulse of light with too low of an intensity is used, a longer time duration is required to reach the temperature required for ejecting functional material **36** from plate **31.** This means that due to thermal diffusion, more of functional material **36** will be heated before it is eventually ejected. This is undesirable for many type of functional materials. Thus, for smaller wells, a higher amount of functional material **36** will be affected.

Since the source of light is noncollimated, it is possible to utilize the present invention to print functional material onto a nonplanar substrate, e.g., a three-dimensional structure. In this case, the surface having the wells may be discontinuous or curved to match the surface of the receiving substrate. This may have useful applications such as printing an antenna onto a curved surface either concave or convex or even over discontinuous surfaces.

The following are additional types of layers that allow the method of the present invention to be even more flexible and more advantageous.

### Reflective layer

A reflective layer can be applied on second surface **33** of plate **31** before the application of light-absorbing material layer **34** on second surface **33** of plate **31.** The reflective layer can then be selectively etched away before light-absorbing material layer **34** is applied. When having a high contrast ratio between the reflective layer and light-absorbing material layer **34,** it is possible to only reach the phase change temperature within well **36** and not on the flat part of plate **31.** As filling wells **35** might not be a 100% clean process, the reflective layer prevents that functional material **36** on the flat part of plate **31** does not reach the phase change temperature. A possible material for the reflective layer is aluminum.

### Thermal buffer layer

A thermal buffer layer can be applied on second surface **33** of plate **31** before the application of light-absorbing material layer **34** on second surface **33** of plate **31.** The thermal buffer layer exhibits a low thermal conductivity. When the thermal buffer layer has a lower thermal conductivity than plate **31,** it retards the heat pulse from light-absorbing material layer **34** on the flat part of plate **31.**

An example of a thermal buffer layer is a polymer such is polyimide. Polyimide has a thermal conductivity of about 0.5 W/m-K, which is a factor of approximately 2.5 lower than that of quartz. The thickness of the thermal buffer layer is preferably less than 10 micron.

### Release layer

Before an application of functional material **36,** a thin layer of material having a relatively low boiling point may be applied to facilitate the release of functional material **36** from plate **31.** The application can be performed by a number of deposition technologies such as roll coating, vapor deposition, misting, etc. Preferably, the release layer has a phase change temperature equal to or lower than any of the solvents or components in functional material **36.** A possible material for the release layer is polypropylene carbonate).

The release layer may also be absorptive of light. In this case, it can serve as the absorptive layer as well. It must be re-applied for each printing step.

### Porous Release layer

The release mechanism of functional material **36** can be improved by applying a thin micro- or nano-structural layer within well **35,** between functional material **36** and light-absorbing material layer **34.** The release structure needs to be able to contain a solvent, so it has to have pores. Depending on the particle size of functional material **36,** the pore size can be either in the micrometer- or nanometer-range. The pores in the release structure are filled with a low boiling point solvent before application of functional material **36.** Typically, a low boiling point solvent also has a low phase change temperature, meaning that functional material **36** can be printed with a lower energy light pulse. Alternatively, the solvent from functional material **36** can preferentially go into the pores when it is applied. In both cases, the gas generation within the release structure is less dependent on the properties of functional material **36.** This should lead to a more homogeneous process. Also, thermal damage to functional material **36** can be further prevented, as it is not heated in a direct manner.

This may be important when printing biological materials that are thermally fragile. Even without the release layer, this is a "cold" printing process as there is little time to transfer much heat. Functional material 36 will always heat up until it reaches the phase change temperature. However, it is typically less than 1 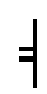 m of material that is significantly heated. However, with the release layer, the peak temperature seen by functional material 36 is reduced further.

An alternative to a porous release layer structure for the purpose of helping to eject the functional material is the application of a low surface tension layer between light-absorbing material layer **34** and functional material **36** to enhance the release of functional material **36** as well as enhance the cleanability of the surface after printing and before the subsequent application of more functional material **36.** The low surface tension layer may also be selectively applied within a well so as to encourage deposition of functional material **36** onto desired portions of wells **35.**

Light-absorbing material layer **34** may be selectively coated with the low surface tension layer to functional material **36** to aid in releasing functional material **36** from wells **35.**

As has been described, the present invention provides a method for depositing a functional layer on a substrate. Unlike the LIFT process, the method of the present invention requires no scanning. Unlike the LIFT process, nearly 100% of the functional material is utilized by the method of the present invention. Unlike the LIFT process, there is no by-product or waste such as unused paste or transfer tape with the method of the present invention.

While the invention has been particularly shown and described with reference to a preferred embodiment, it will be understood by those skilled in the art that various changes in form and detail may be made therein without departing from the spirit and scope of the invention.
The following numbered clauses, describing aspects of our proposals, are part of the description:
1. A method for depositing a functional material on a substrate, said method comprising:
   providing a plate having a first surface and a second surface with at least one well;
   applying a thin layer of light-absorbing material onto said second surface of said plate;
   filling said at least one well of said plate with a functional material; and
   irradiating said plate with a pulsed light from a non-collimated light source to heat said light-absorbing material in order to generate gas at an interface between said light-absorbing material and said functional material to release said functional material from said at least one well onto a receiving substrate.
2. The method of Clause 1, wherein said plate is optically transparent.
3. The method of Clause 1, wherein said plate is made of quartz.
4. The method of Clause 1, wherein said light-absorbing material is tungsten.
5. The method of Clause 1, wherein said non-collimated light source is a flashlamp.
6. The method of Clause 1, wherein said non-collimated light source is a laser and a waveguide.
7. The method of Clause 1, wherein an intensity of said pulsed light is greater than 10KW/cm².
8. The method of Clause 1, wherein a pulse width of said pulsed light is less than 0.2 ms.
9. The method of Clause 1, wherein said method further includes applying a reflective layer on said second surface of said plate before the application of said light-absorbing material layer.
10. The method of Clause 9, wherein said method further includes selectively removing said reflective layer from said second surface of said plate before the application of said light-absorbing material layer.
11. The method of Clause 1, wherein said applying further includes applying a thin release layer onto said second surface of said plate after said application of said light-absorbing material and before said application of said functional material.
12. The method of Clause 11, wherein said release layer is porous and contains a low boiling point solvent.
13. The method of Clause 11, wherein said release layer has a relatively low phase change temperature.
14. The method of Clause 11, wherein said release layer has a relatively low surface tension.
15. The method of Clause 1, wherein said applying further includes applying a thin thermal buffer layer onto said second surface of said plate before said application of said light-absorbing material.
16. The method of Clause 15, wherein said thermal buffer layer is made of polyimide.
17. The method of Clause 1, wherein said second surface is substantially flat.
18. The method of Clause 1, wherein said second surface is curved.
19. The method of Clause 1, wherein said receiving substrate is curved.

## Claims

1. A method for depositing a functional material on a substrate, said method comprising:
providing a plate (31) having a first surface (32) and a second surface (33) with at least one well (35);
applying a reflective layer on the second surface (33) and selectively removing the reflective layer from said at least one well;
applying a layer of light-absorbing material (34) onto said reflective layer and, where the reflective layer has been selectively removed, onto said second surface (33) of said plate;
filling said at least one well (35) of said plate (31) with a functional material (36); and
irradiating said plate with a pulsed light from a non-collimated light source (37) to heat said light-absorbing material (34) in order to generate gas at an interface between said light-absorbing material (34) and said functional material (36) to release said functional material from said at least one well (35) onto a receiving substrate (38).

2. The method of Claim 1, wherein said plate (31) is optically transparent and the method comprises irradiating said plate through the first surface (31).

3. The method of Claim 1, wherein said plate (31) is made of quartz.

4. The method of Claim 1, wherein said light-absorbing material (34) is tungsten.

5. The method of Claim 1, wherein said non-collimated light source (37) is a flashlamp.

6. The method of Claim 1, wherein said non-collimated light source (37) is a laser and a waveguide.

7. The method of Claim 1, wherein an intensity of said pulsed light is greater than 10KW/cm².

8. The method of Claim 1, wherein a pulse width of said pulsed light is less than 0.2 ms.

9. The method of Claim 1, wherein the method further includes after said application of said light-absorbing material (34) and before said application of said functional material (36), applying a release layer onto said light-absorbing material.

10. The method of Claim 9, wherein said release layer is porous and the pores contain a solvent having a phase change temperature equal to or lower than any solvents or components in the functional material (36).

11. The method of Claim 9, wherein said release layer has a phase change temperature equal to or lower than any solvents or components in the functional material (36).

12. The method of Claim 9, wherein said release layer is polypropylene carbonate).
